(19) Europäisches Patentamt
European Patent Office
Office européen des brevets

(11) Veröffentlichungsnummer: **0 443 415 A2**

(12) # EUROPÄISCHE PATENTANMELDUNG

(21) Anmeldenummer: **91101944.6**

(51) Int. Cl.[5]: **G03F 7/004**

(22) Anmeldetag: **12.02.91**

(30) Priorität: **20.02.90 DE 4005212**

(43) Veröffentlichungstag der Anmeldung:
**28.08.91 Patentblatt 91/35**

(84) Benannte Vertragsstaaten:
**BE DE FR GB IT NL**

(71) Anmelder: **BASF Aktiengesellschaft**
**Carl-Bosch-Strasse 38**
**W-6700 Ludwigshafen(DE)**

(72) Erfinder: **Nguyen Kim, Son**
**Zedernweg 9**
**W-6944 Hemsbach(DE)**

(54) **Strahlungsempfindliches Gemisch.**

(57) Die Erfindung betrifft ein strahlungsempfindliches Gemisch, im wesentlichen bestehend aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung und

(c) einer oder mehreren die Löslichkeit von (a) in wäßrig-alkalischen Lösungen inhibierenden organischen Verbindungen,

wobei die Komponente (c) eine organische Verbindung der allgemeinen Formel

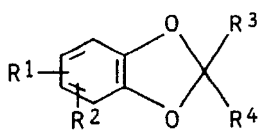

(I)

ist, worin

$R^1$ und $R^2$ für Wasserstoff, Alkyl, Alkoxi, Aryl oder Aralkyl stehen und

$R^3$ und $R^4$ für Alkyl, Cycloalkyl, Aralkyl, Aryl oder den Rest

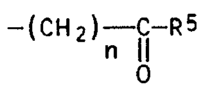

mit $n = 1$ bis 5 und $R^5$ = Alkyl, Alkoxi, Aryl oder Aralkyl stehen oder $R^3$ zusammen mit $R^4$ über

$$-(CH_2)_m$$

mit $m = 4$ bis 6 einen fünf- bis siebengliedrigen Ring bilden.

Dieses strahlungsempfindliche Gemisch eignet sich zur Herstellung von Reliefstrukturen.

EP 0 443 415 A2

Die Erfindung betrifft positiv arbeitende strahlungsempfindliche Gemische, die ein in Wasser unlösliches, in wäßrig-alkalischen Lösungen lösliches Bindemittel, eine unter Einwirkung von Strahlung eine Säure bildende Verbindung und eine organische Verbindung, die durch säurekatalytische Einwirkung verseift wird, wodurch die Alkalilöslichkeit des Gemisches erhöht wird, enthalten. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly-(p-vinylphenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslöst, sind beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Strahlungsempfindliche Gemische von Polymeren mit säurelabilen Seitengruppen und photochemischen Säurespendern sind z.B. aus US-A 4,491,628 und FR-A 2,570,844 bekannt. Diese polymeren Bindemittel sind jedoch hydrophob und werden erst nach der Belichtung alkalilöslich.

Copolymere mit phenolischen und säurelabilen Gruppen, wie beispielsweise Poly-(p-hydroxistyrol-co-t-butoxicarbonyloxistyrol), sind aus J. Polym. Sci. , Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylsulfoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen. Weiterhin tragen diese Salze nach der Belichtung nicht zu einer Löslichkeitserhöhung der bestrahlten Bereiche in alkalischen Entwicklern bei, da keine alkalilöslichen Photoprodukte entstehen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das ein in Wasser unlösliches, in wäßrig-alkalischer Lösung lösliches Bindemittel, eine säurelabile organische Verbindung, die durch Einwirkung von Säure verseift wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

Überraschenderweise wurde gefunden, daß durch den Einsatz von bestimmten Brenzkatechinderivaten als die Löslichkeit der Bindemittel in wäßrigalkalischen Lösungen inhibierenden Verbindungen hochaktive strahlungsempfindliche Systeme für die Herstellung von Reliefstrukturen im kurzwelligen UV erhalten werden, die sich besonders durch sehr gute Reproduzierbarkeit und hohe Auflösung, besonders in Kombination mit Bindemitteln auf Novolak-Basis auszeichnen.

Gegenstand der vorliegenden Erfindung ist ein Strahlungsempfindliches Gemisch, im wesentlichen bestehend aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung und

(c) einer oder mehreren die Löslichkeit von (a) in wäßrig-alkalischen Lösungen inhibierenden organischen Verbindungen,

das dadurch gekennzeichnet ist, daß die organische Verbindung (c) eine organische Verbindung der allgemeinen Formel (I)

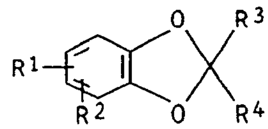

(I)

ist, worin
$R^1$ und $R^2$ untereinander gleich oder verschieden sind und für Wasserstoff, Alkyl, Alkoxi, Aryl oder Aralkyl stehen,
$R^3$ und $R^4$ untereinander gleich oder verschieden sind und für Alkyl, Cycloalkyl, Aralkyl, gegebenenfalls alkyl- oder halogensubstituiertes Aryl oder den Rest

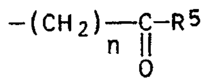

mit n = 1 bis 5 und $R^5$ = Alkyl, Alkoxi, Aryl oder Aralkyl stehen
oder $R^3$ zusammen mit $R^4$ über

$$-(CH_2)_m$$

mit m = 4 bis 6 einen fünf- bis siebengliedrigen Ring bildet.

Das erfindungsgemäße strahlungsempfindliches Gemisch kann als Bindemittel (a) ein phenolisches Harz, wie z.B. einen Novolak mit einem mittleren Molekulargewicht $\overline{M}_w$ zwischen 300 und 20.000 oder Poly-(p-hydroxistyrol), Poly(p-hydroxi-α-methylstyrol) oder Copolymerisate aus p-Hydroxistyrol und p-tert.-Butoxicarbonyloxistyrol, aus p-Hydroxistyrol und Alkoxistyrol oder aus p-Hydroxistyrol und 2-Tetrahydropyranyloxistyrol - wobei diese Copolymerisate auch durch polymeranaloge Umsetzung hergestellt sein können -, jeweils mit mittleren Molekulargewichten $\overline{M}_w$ zwischen 200 und 200.000 enthalten.

Die Bindemittelkomponente (a) ist dabei im allgemeinen in einer Menge von 50 bis 95 Gew.-%, bezogen auf die Gesamtmenge der Komponenten (a) + (b) + (c) enthalten, mit der Maßgabe, daß die Summe der unter (a), (b) und (c) genannten Prozentzahlen gleich 100 ist.

Als bei Bestrahlung eine starke Säure bildende Verbindung (b) kommen vorzugsweise Oniumsalze der allgemeinen Formel (II) oder (III)

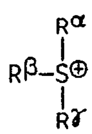 $X^{\ominus}$ oder 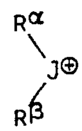 $X^{\ominus}$

(II) (III)

in Betracht, worin $R^\alpha$, $R^\beta$ und $R^\gamma$ untereinander gleich oder verschieden sind und für Alkyl, Aryl, Aralkyl oder den Rest

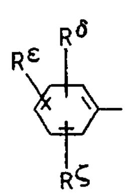

stehen, worin $R^\delta$, $R^\epsilon$ und $R^\zeta$ untereinander gleich oder verschieden sind und für H, OH, Halogen, Alkyl oder Alkoxi stehen und $X^\ominus$ = $AsF_6^\ominus$, $SbF_6^\ominus$, $PF_6^\ominus$, $BF_4^\ominus$, $ClO_4^\ominus$, $CH_3SO_3^\ominus$ oder $CF_3SO_3^\ominus$ ist.

Komponente (b) ist im allgemeinen in einer Menge von 1 bis 20 Gew.-%, bezogen auf die Gesamtmenge der Komponenten (a) + (b) + (c) enthalten.

Als die Löslichkeit von Komponente (a) in wäßrig alkalischen Lösungen inhibierende organische Verbindung (c) enthält das erfindungsgemäße strahlungsempfindliche Gemisch vorzugsweise mindestens eine der Verbindungen

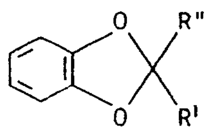 , 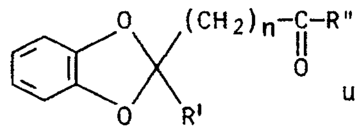 und/oder 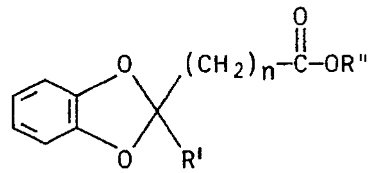 ,

worin R' und R" untereinander gleich oder verschieden sind und für Alkyl mit 1 bis 6 Kohlenstoffatomen, Phenyl oder Benzyl stehen und n = 1 ist, wobei Komponente (c) im allgemeinen in einer Menge von 1 bis 49 Gew.-%, bezogen auf die Gesamtmenge der Komponenten (a) + (b) + (c) enthalten ist. Die Summe der jeweils unter (a), (b) und (c) genannten Prozentzahlen beträgt 100.

Das erfindungsgemäße strahlungsempfindliche Gemisch kann zusätzlich einen Sensibilisator enthalten, der Strahlung absorbiert und auf Komponente (b) überträgt, oder zusätzlich bis zu 1 Gew.-%, bezogen auf die Gesamtmenge der Komponenten (a) + (b) + (c) eines Haftvermittlers, Tensids oder Farbstoffs.

Gegenstand der vorliegenden Erfindung ist außerdem ein Verfahren zur Herstellung von Reliefstrukturen oder zur Strukturierung von Wafern durch Auftragen von Photoresistlösungen in einer Schichtdicke von 0,1 bis 5 µm auf ein in üblicher Weise vorbehandeltes Substrat, Trocknen, bildmäßige Belichtung, gegebenenfalls Erhitzen auf Temperaturen von bis zu 150 °C, und Entwickeln mit einer wäßrig-alkalischen Lösung, das dadurch gekennzeichnet ist, daß Photoresistlösungen eingesetzt werden, die erfindungsgemäße strahlungsempfindliche Gemische enthalten.

Das erfindungsgemäße System ist besonders vorteilhaft, da es sich in Kombination mit den besonders preisgünstigen Bindemitteln auf Novolak-Basis einsetzen läßt. Die damit erhaltenen Reliefstrukturen zeichnen sich durch sehr gute Reproduzierbarkeit und hohe Auflösung aus.

Zu den Aufbaukomponenten des erfindungsgemäßen strahlungsempfindlichen Gemisches ist im einzelnen folgendes auszuführen.

a) Als in Wasser unlösliche, in wäßrig-alkalischen Lösungen lösliche Bindemittel oder Bindemittelgemische kommen wegen der meist erforderlichen Plasmaätzstabilität im allgemeinen phenolische Harze in Betracht, wie z.B. Novolake mit Molekulargewichten $\overline{M}_w$ zwischen 300 und 20.000, vorzugsweise zwischen 300 und 2000 g/mol, für Belichtung im kurzwelligen UV-Bereich ($\leq$ 300 nm) insbesondere Novolake auf Basis p-Kresol/Formaldehyd, Poly(p-hydroxistyrole) und Poly(p-hydroxy-$\alpha$-methylstyrole), wobei diese Poly(p-hydroxistyrole) im allgemeinen Molekulargewichte $\overline{M}_w$ zwischen 200 und 200.000, vorzugsweise zwischen 1000 und 40.000 g/mol aufweisen, wobei diese Poly(p-hydroxistyrole) auch in bekannter Weise durch Umsetzung (polymeranaloge Umsetzung) ihrer Hydroxylgruppen mit z.B. Chloressigsäure, Chloressigsäureester, Alkylhalogenid, Benzylhalogenid, 3,4-Dihydropyran, Dihydrofuran, Chlorkohlensäureester und/oder Pyrokohlensäureester modifiziert sein können. Die so erhältlichen und im vorliegenden Falle auch als Copolymerisate verstandenen modifizierten polymeren Bindemittel (a) sind beispielsweise solche aus p-Hydroxistyrol und p-tert.-Butoxicarbonyloxistyrol, p-Hydroxistyrol und Alkoxistyrol sowie p-Hydroxistyrol und 2-Tetrahydropyranyloxistyrol. Bevorzugte Copolymere von p-Hydroxistyrol, die seitenständige Schutzgruppen enthalten, enthalten im wesentlichen Gruppierungen

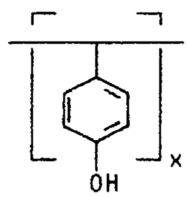

und

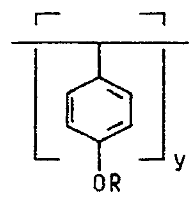

worin x ≥ y und

R = 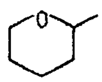 , 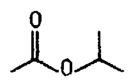 , 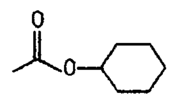 ,

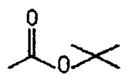 , 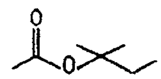

d.h. Copolymere mit p-(2-Tetrahydropyranyl)-oxistyrol-, p-(iso-Propyloxicarbonyl)-oxistyrol-, p-(Cyclohexyl-oxicarbonyl)-oxistyrol-, p-(t.Butyloxicarbonyl)-oxistyrol- und/oder p-(t.Pentyloxicarbonyl)-oxistyroleinheiten.

Es eignen sich auch Gemische der obengenannten Bindemittel (a). Bindemittel (a) ist im erfindungsgemäßen Gemisch im allgemeinen in Mengen von 50 bis 95, vorzugsweise 70 bis 85 Gew.%, bezogen auf die Gesamtmenge des strahlungsempfindlichen Gemisches (a) + (b) + (c) enthalten.

b) Als bei Bestrahlung eine starke Säure bildende Verbindungen (b) kommen im Prinzip alle Verbindungen in Frage, die diese Eigenschaft aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen den allgemeinen Formeln (II) bzw. (III)

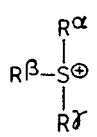

bzw.

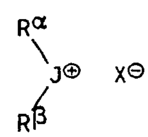

(II) (III)

worin

$R^\alpha$, $R^\beta$ und $R^\gamma$ untereinander gleich oder verschieden sind und für Alkyl, beispielsweise mit 1 bis 5, vorzugsweise 1 oder 2 Kohlenstoffatomen, Aryl, wie z.B. Phenyl,

Aralkyl, wie z.B. Benzyl,

oder den Rest

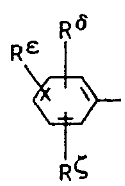

stehen, worin $R^\delta$, $R^\epsilon$ und $R^\zeta$ untereinander gleich oder verschieden sind und für Wasserstoff, OH, Halogen, wie z.B. Chlor oder Brom, Alkyl, beispielsweise mit 1 bis 5 Kohlenstoffatomen, vorzugsweise Methyl oder tert.-Butyl,

oder Alkoxi, beispielsweise mit 1 bis 5 Kohlenstoffatomen, vorzugsweise Methoxy

stehen und $X^\ominus$ = $AsF_6^\ominus$, $SbF_6^\ominus$, $PF_6^\ominus$, $BF_4^\ominus$, $ClO_4^\ominus$, $CH_3SO_3^\ominus$ oder $CF_3SO_3^\ominus$ (= Triflat) ist.

Beispiele für besonders gut geeignete Komponenten (b) sind Triphenylsulfoniumsalze und Diphenyliodoniumsalze, Tris(4-hydroxiphenyl)sulfoniumsalze, Tris(trimethylsilyloxi-phenyl)sulfoniumsalze, Tris(4-tert.-butoxicarbonyl-oxiphenyl)sulfoniumsalze und Tris(4-ethyloxicarbonyl-oxiphenyl)sulfoniumsalze, je-

weils mit $x^{\ominus}$ = $ClO_4^{\ominus}$, $AsF_6^{\ominus}$, $PF_6^{\ominus}$, $SbF_6^{\ominus}$, $BF_4^{\ominus}$, $CH_3SO_3^{\ominus}$ und $CF_3SO_3^{\ominus}$ als Gegenionen.

Auch Gemische der unter (b) genannten Verbindungen können eingesetzt werden. Komponente (b) ist im erfindungsgemäßen strahlungsempfindlichen Gemisch im allgemeinen in Mengen von 1 bis 20, vorzugsweise 3 bis 10 Gew.%, bezogen auf die Gesamtmenge des strahlungsempfindlichen Gemisches (a) + (b) + (c) enthalten.

c) Als die Löslichkeit des Bindemittels (a) inhibierende organische Verbindung (c) werden erfindungsgemäß organische Verbindungen der allgemeinen Formel (I) eingesetzt,

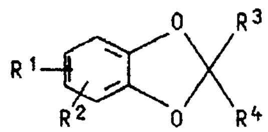

(I)

worin

$R^1$ und $R^2$ untereinander gleich oder verschieden sind für Wasserstoff, Alkyl, beispielsweise mit 1 bis 5 Kohlenstoffatomen, vorzugsweise Methyl oder tert.-Butyl,
Alkoxi, beispielsweise mit 1 bis 5 Kohlenstoffatomen, vorzugsweise Methoxi,
Aryl, wie z.B. Phenyl, Aralkyl, wie z.B. Benzyl stehen,
$R^3$ und $R^4$ untereinander gleich oder verschieden sind und für Alkyl, beispielsweise mit 1 bis 5, vorzugsweise 2 bis 4 Kohlenstoffatomen, z.B. Ethyl, n-Propyl, n-Butyl,
Aralkyl mit 1 bis 2 Kohlenstoffatomen in der Alkylgruppe, wie Benzyl, halogensubstituiertes Aralkyl, wie z.B. p-Chlorbenzyl, Aryl, wie z.B. Phenyl, alkylsubstituiertes Aryl, wie Tolyl, alkoxisubstituiertes Aryl, wie Methoxiphenyl, halogen- (wie z.B. F-, Cl-, Br-, J-, vorzugsweise Cl- oder Br-)substituiertes Aryl, wie z.B. p-Chlorphenyl, oder den Rest

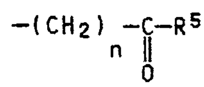

mit n = 1 bis 5, vorzugsweise 1, und $R^5$ = Alkyl mit z.B. 1 bis 5 Kohlenstoffatomen, vorzugsweise einem Kohlenstoffatom,
Alkoxi mit z.B. 1 bis 5, vorzugsweise 1 bis 4 Kohlenstoffatomen, wie z.B. Methoxi, Ethoxi und tert.-Butoxi,
Aryl, wie z.B. Phenyl,
oder Aralkyl, z.B. mit 1 bis 2 Kohlenstoffatomen in der Alkylgruppe, wie Benzyl
stehen oder $R^3$ zusammen mit $R^4$ über $-(CH_2)_m-$ mit m = 4 bis 6, vorzugsweise 5,
einen fünf- bis siebengliedrigen, vorzugsweise sechsgliedrigen Ring bilden.

Bevorzugte organische Verbindungen (c) sind

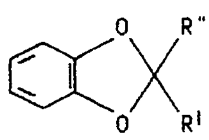 , 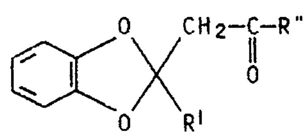 und 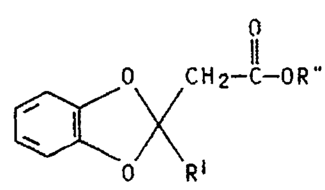 ,

worin R' und R" untereinander gleich oder verschieden sind und für Alkyl mit 1 bis 6 Kohlenstoffatomen, vorzugsweise 2 bis 4 Kohlenstoffatomen, Phenyl oder Benzyl stehen.

Beispiele für bevorzugte organische Verbindungen (c) sind:

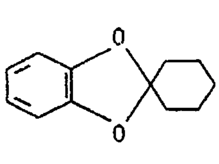 , 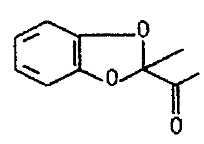 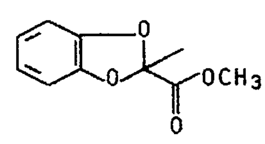 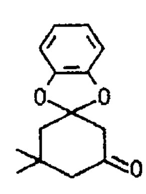

Auch Gemische der obengenannten organischen Verbindungen (c) können eingesetzt werden. Organische Verbindungen (c) können nach bekannten Verfahren, wie sie beispielsweise in Protective Groups in Organic Synthesis, Seite 108 ff. beschrieben sind, beispielsweise aus Brenzkatechin und Carbonylverbindungen, z.B. Cyclohexanon in Gegenwart von Säure hergestellt werden können.

Komponente (c) ist im erfindungsgemäßen strahlungsempfindlichen Gemisch im allgemeinen in Mengen von 1 bis 49, vorzugsweise 10 bis 27 Gew.-%, bezogen auf die Gesamtmenge der Komponenten (a) + (b) + - (c) enthalten.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone, wie beispielsweise Cyclohexanon. Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden, im allgemeinen in Mengen von bis zu 1 Gew.-%.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch andere Farbstoffe, die als Sensibilisatoren wirken, verwendet werden.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche in wäßrig-alkalischen Lösungsmitteln zunimmt und diese bestrahlten Bereiche selektiv mit dem alkalischen Entwickler entfernt werden können.

Besondere Vorteile der erfindungsgemäßen strahlungsempfindlichen Gemische sind sehr gute Reproduzierbarkeit, hohe Auflösung und hohe Empflindlichkeit im kurzwelligen UV-Bereich.

Die das erfindungsgemäße strahlungsempfindliche Gemisch enthaltenden Photoresistlösungen werden im allgemeinen in Schichtdicken von 0,1 bis 5 $\mu$m, vorzugsweise 0,5 bis 1,5 $\mu$m auf geeignete Substrate, beispielsweise oberflächlich oxidierte Silizium-Wafer durch Aufschleudern (spin coating) aufgetragen, getrocknet (z.B. bei Temperaturen zwischen 70 und 130°C) und mit einer geeigneten Lichtquelle durch eine Photomaske bildmäßig belichtet. Als Lichtquellen eignen sich insbesondere kurzwellige UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 150°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 80 und 250 mJ/cm$^2$ bei Schichtdicken von 1 $\mu$m.

Die in den Beispielen angegebenen Teile und Prozente sind, soweit nicht anders angegeben, Gewichtsteile bzw. Gewichtsprozente.

Beispiel 1

Eine Photoresistlösung wird aus 80 Teilen eines Poly(p-hydroxistyrol) mit einem mittleren Molekulargewicht $\overline{M}_w$ von 7000,
5 Teilen Tris(4-hydroxiphenyl)sulfoniumtriflat, 15 Teilen der Verbindung

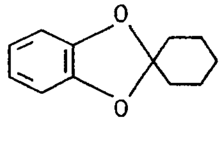

und 250 Teilen Ethylenglykol-monomethyletheracetat hergestellt.

Die Lösung wird anschließend durch ein Filter mit einem Porendurchmesser von 0,2 µm filtriert.

Die Resistlösung wird auf einen Siliciumwafer, der mit Hexamethyldisilazan als Haftvermittler überzogen ist, mit 4000 Upm/30 Sekunden aufgeschleudert, wobei eine Schichtdicke von etwa 1 µm erhalten wird. Der Wafer wird während 3 Minuten auf einer Heizplatte bei 80 °C getrocknet, anschließend mit einer bildmäßig strukturierten Testmaske in Kontakt gebracht und mit einem Excimer-Laser ($\lambda$ = 248 nm, E = 35 mW/cm$^2$) belichtet. Danach wird der Wafer 1 Minute bei 80 °C ausgeheizt und mit einem Entwickler vom pH-Wert 12,0-13,6 entwickelt. Die Lichtempfindlichkeit beträgt 150 mJ/cm$^2$.

Beispiel 2

Eine Photoresistlösung wird durch Mischen von
70 Teilen Kresol/Formaldehyd-Novolak ($\overline{M}_w$: ca. 300),
5 Teilen Triphenylsulfoniumhexafluoroarsenat (Handelsprodukt der Fa. ALFA),
25 Teilen der Verbindung

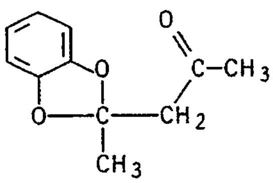

sowie 250 Teilen Ethylenglykol-mono-methyletheracetat
hergestellt und wie in Beispiel 1 beschrieben weiterverarbeitet. Man erhält eine Lichtempfindlichkeit = 190 mJ/cm$^2$.

Beispiel 3

Eine Photoresistlösung aus
70 Teilen Poly(p-hydroxistyrol) ($\overline{M}_w$: 7000),
5 Teilen Triphenylsulfoniumhexafluoroarsenat,
25 Teilen der Verbindung

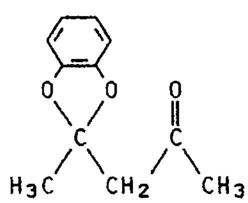

und 250 Teilen Ethylenglykol-mono-methyletheracetat
wird analog Beispiel 1 weiterverarbeitet. Man erhält eine Lichtempfindlichkeit = 80 mJ/cm$^2$.

**Patentansprüche**

1. Strahlungsempfindliches Gemisch, im wesentlichen bestehend aus
   (a) einem in Wasser unlöslichen, in wäßrig-alkalischen Lösungen löslichen Bindemittel oder Bindemittelgemisch,
   (b) einer bei Bestrahlung eine starke Säure bildenden Verbindung und
   (c) einer oder mehreren die Löslichkeit von (a) in wäßrig-alkalischen Lösungen inhibierenden organischen Verbindungen,

   dadurch gekennzeichnet, daß die organische Verbindung (c) eine organische Verbindung der allgemeinen Formel (I)

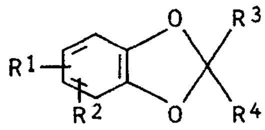

(I)

ist, worin

$R^1$ und $R^2$ untereinander gleich oder verschieden sind und für Wasserstoff, Alkyl, Alkoxi, Aryl oder Aralkyl stehen,

$R^3$ und $R^4$ untereinander gleich oder verschieden sind und für Alkyl, Cycloalkyl, Aralkyl, gegebenenfalls alkyl- oder halogensubstituiertes Aryl oder den Rest

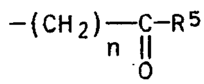

mit n = 1 bis 5 und $R^5$ = Alkyl, Alkoxi, Aryl oder Aralkyl stehen

oder $R^3$ zusammen mit $R^4$ über

$$-(CH_2)_m$$

mit m = 4 bis 6 einen fünf- bis siebengliedrigen Ring bildet.

2. Strahlungsempfindliches Gemisch nach Anspruch 1, dadurch gekennzeichnet, daß als Bindemittel (a) ein phenolisches Harz eingesetzt wird.

3. Strahlungsempfindliches Gemisch nach Anspruch 2, dadurch gekennzeichnet, daß als phenolisches Harz ein Novolak mit einem mittleren Molekulargewicht $\overline{M}_w$ zwischen 300 und 20.000 eingesetzt wird.

4. Strahlungsempfindliches Gemisch nach Anspruch 1, dadurch gekennzeichnet, daß als Bindemittel (a) Poly(p-hydroxistyrol), Poly(p-hydroxi-α-methylstyrol) oder Copolymerisate aus p-Hydroxistyrol und p-tert.-Butoxicarbonyloxistyrol, aus p-Hydroxistyrol und Alkoxistyrol oder aus p-Hydroxistyrol und 2-Tetrahydropyranyloxistyrol - wobei diese Copolymerisate auch durch polymeranaloge Umsetzung hergestellt sein können -, jeweils mit mittleren Molekulargewichten $\overline{M}_w$ zwischen 200 und 200.000 eingesetzt wird.

5. Strahlungsempfindliches Gemisch nach einem der vorhergehenden Ansprüche, dadurch gekennzeichnet, daß die Bindemittelkomponente (a) in einer Menge von 50 bis 95 Gew.-%, bezogen auf die Gesamtmenge der Komponenten (a)+(b)+(c) enthalten ist, mit der Maßgabe, daß die Summe der unter (a), (b) und (c) genannten Prozentzahlen gleich 100 ist.

6. Strahlungsempfindliches Gemisch nach einem der vorhergehenden Ansprüche, dadurch gekennzeichnet, daß als bei Bestrahlung eine starke Säure bildende Verbindung (b) ein Oniumsalz der allgemeinen Formel (II) oder (III)

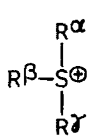 $X^{\ominus}$ oder 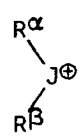 $X^{\ominus}$

(II) (III)

eingesetzt wird, worin $R^\alpha$, $R^\beta$ und $R^\gamma$ untereinander gleich oder verschieden sind und für Alkyl, Aryl, Aralkyl oder den Rest

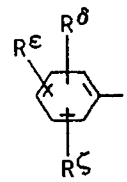

stehen, worin $R^\delta$, $R^\epsilon$ und $R^\zeta$ untereinander gleich oder verschieden sind und für H, OH, Halogen, Alkyl oder Alkoxi stehen und $X^\ominus$ = $AsF_6^\ominus$, $SbF_6^\ominus$, $PF_6^\ominus$, $BF_4^\ominus$, $ClO_4^\ominus$, $CH_3SO_3^\ominus$ oder $CF_3SO_3^\ominus$ ist.

**7.** Strahlungsempfindliches Gemisch nach einem der vorhergehenden Ansprüche, dadurch gekennzeichnet, daß Komponente (b) in einer Menge von 1 bis 20 Gew.-%, bezogen auf die Gesamtmenge der Komponenten (a) + (b) + (c) enthalten ist.

**8.** Strahlungsempfindliches Gemisch nach einem der vorhergehenden Ansprüche, dadurch gekennzeichnet, daß Komponente (c) in einer Menge von 1 bis 49 Gew.-%, bezogen auf die Gesamtmenge der Komponenten (a) + (b) + (c) enthalten ist.

**9.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

**10.** Strahlungsempfindliches Gemisch nach einem der vorhergehenden Ansprüche, dadurch gekennzeichnet, daß es zusätzlich bis zu 1 Gew.-%, bezogen auf die Gesamtmenge der Komponenten (a) + (b) + (c) eines Haftvermittlers, Tensids oder Farbstoffs enthält.

**11.** Verfahren zur Herstellung von Reliefstrukturen oder zur Strukturierung von Wafern durch Auftragen von Photoresistlösungen in einer Schichtdicke von 0,1 bis 5 $\mu$m auf ein in üblicher Weise vorbehandeltes Substrat, Trocknen, bildmäßige Belichtung, gegebenenfalls Erhitzen auf Temperaturen von bis zu 150 °C, und Entwickeln mit einer wäßrig-alkalischen Lösung, dadurch gekennzeichnet, daß Photoresistlösungen eingesetzt werden, die strahlungsempfindliche Gemische gemäß einem der Ansprüche 1 bis 10 enthalten.